# EUROPEAN PATENT APPLICATION

(11) **EP 4 440 274 A1**
(43) Date of publication of application: **02.10.2024**
(21) Application number: 22916425.6
(22) Date of filing: 16.11.2022
(51) Int. Cl.: H05K 13/04, B23K 3/047, H05K 13/00

(54) **INDUCTION-HEATED SOLDERING AUTOMATION EQUIPMENT**

(30) Priority: 29.12.2021 KR 20210190807
(71) Applicant: BS Technics Co., Ltd., Ansan-si, Gyeonggi-do 15407 (KR)
(72) Inventor: KIM, Jun Sik, Gwacheon-si Gyeonggi-do 13835 (KR); KIM, Young Do, Ansan-si Gyeonggi-do 15324 (KR); CHOI, Jung Sik, Siheung-si Gyeonggi-do 15010 (KR); JUNG, Tae Kyoung, Bucheon-si Gyeonggi-do 14782 (KR); KIM, Seung Ho, Osan-si Gyeonggi-do 18125 (KR); PARK, In Ho, Incheon 21535 (KR)
(74) Representative: BCKIP Part mbB
(86) International application number: PCT/KR2022/018088
(87) International publication number: WO 2023/128271

(57) **Abstract**

The present invention relates to induction-heated soldering automation equipment and, particularly, to equipment comprising: a jig unit for fixing a substrate on which an electronic element is mounted; a first conveyor for transferring the jig unit; an induction heating unit which is provided above the jig unit so as to be movable in the X-axis, Y-axis, and Z-axis directions, and which includes a magnetic induction coil for soldering the electronic element by induction-heating the substrate fixed to the jig unit; and a controller for controlling the first conveyor and the induction heating unit, wherein continuously supplied molded interconnected devices (MIDs), PCBs, or FPCBs are locally heated through contactless induction heating so that electronic elements can be automatically soldered in a state in which thermal damage is minimized.

## Description

### TECHNICAL FIELD

The present invention relates to induction heating soldering automation equipment, and more particularly, to an induction heating soldering automation equipment that is capable of continuously and automatically soldering electronic elements by inductively heating a molded interconnected device (MID) or PCB on which the continuously supplied electronic elements are mounted.

### BACKGROUND ART

Recently, in various industries, circuits to which electrical circuits are applied are essential in all fields such as connection between components, control, and sensing.

A method for implementing circuits in accordance with the related art includes a method of soldering elements on a PCB or FPCB or assembling elements using a wire harness.

In the case of the PCB, necessary electronic components are soldered to a portion at which the electric circuit is implemented in 2D form so as to be electrically circuited in the most common electric circuit method. This method is the most widely used circuit implementation method in most industries, in which a pattern is implemented on a board by photoresist, and solder paste is applied in a metal mask or dispensing manner to mount the electronic component, thereby manufacturing the board through reflow.

Recently, circuit products with a molded interconnected device (MID) structure to which laser direct structuring (LDS) and microscopic integrated processing technology (Miptec) technologies are applied have been introduced. In the case of the MID, since the circuit is implemented directly on a plastic base, the circuit may be implemented in 3D, which is very advantageous in terms of space limitation and installation.

However, when the MID soldering is performed in the reflow manner, since the entire MID passes through a heating furnace that provides high-temperature heat, there is a limitation in using only limited materials because thermal damage occurs to the material, and also, there is a limitation in application to the MID-structured circuit products that have planes with different heights (2.5D) or three-dimensional shapes (3D) due to spatial constraints of the heating furnace.

Due to the above-mentioned limitations, in spite of the advantage of the MID as a very groundbreaking solution for the 3D circuit implementation, it is not widely used in the industry due to the limitations in soldering.

### DISCLOSURE OF THE INVENTION

### TECHNICAL PROBLEM

An object of the present invention is to provide induction heating soldering automation equipment which locally heats a continuously supplied molded interconnected device (MID) or PCB in a non-contact induction heating manner to automatically solder electronic elements to the MID or PCB while minimizing thermal damage.

In addition, an object of the present invention is to provide an induction heating soldering automation equipment that is capable of automatically soldering a plurality of objects to be soldered with uniform quality.

### TECHNICAL SOLUTION

Induction heating soldering automation equipment according to the present invention for achieving the above objects includes: a jig unit configured to fix a board on which an electronic element is mounted; a first conveyor configured to transfer the jig unit; an induction heating unit including a magnetic induction coil installed to be movable in X-axis, Y-axis, and Z-axis directions from an upper side of the jig unit so as to inductively heat the board mounted on the jig unit, thereby soldering the electronic element; and a controller configured to control the first conveyor and the induction heating unit.

In addition, the induction heating soldering automation equipment may further include a pickup robot configured to pick up the jig unit transferred by the first conveyor so as to move on a soldering stage.

Here, a soldering device including the induction heating unit, the pickup robot, and the controller may be provided in plurality along the first conveyor.

Here, a second conveyor configured to transfer the jig unit may be further installed next to the first conveyor.

In addition, a manual stage to/from which the jig unit is manually loaded and unloaded may be provided next to one side of the first conveyor.

Here, the soldering stage, a standby area of the first conveyor, an unloading area of the second conveyor, and the manual stage may be disposed in a straight line along an X-axis direction, and the pickup robot may perform the loading and unloading of the jig unit to the respective areas while moving along the X-axis direction on the respective areas.

Here, the induction heating moving module configured to move the induction heating unit in a three-axis directions such as X, Y, Z axis directions may be provided as a combination of a Y-axis unit supported on a base of a soldering device, an X-axis unit supported on the Y-axis unit, and a Z-axis unit supported on the X-axis unit, and each of the units may be provided with a unit body provided with a guide rail, a driver coupled to one end of the unit body in a longitudinal direction, and a slider moving along the guide rail by driving of the driver.

In addition, the pickup robot may be provided with a pair of robot arms which move along the jig transfer rail in an X-axis direction and are closer or away from each other on the Y-axis to hole the jig unit or release the holding of the jig unit, at a lower end thereof, wherein the robot arms may move in a Z-axis direction by a hydraulic or pneumatic pressure.

Here, the board may include a PCB, an FPCB, or an MID injection-molded product.

The jig unit may include: a bottom plate; a pair of guide plates installed to face each other on both ends of a top surface of the bottom plate; first and second support plates installed to face each other on both the ends of the top surface of the bottom plate; an upper plate provided on upper ends of the pair of guide plates and the first and second support plates and having an insertion hole; a spring installed on the first support plate; a pressing plate configured to receive elastic force from the spring and moving in a state in which a guide protrusion provided at each of both ends thereof is fitted into the guide hole; a fixing member disposed between the second support plate and the pressing plate through the insertion hole of the upper plate and configured to fix the board.

Here, the fixing member may include: a plurality of fixing panels disposed between the second support plate and the pressing plate to generate a gap in which the board is disposed; and a finishing panel installed on an end of one side of each of the fixing panels so as to be in contact with the second support plate.

In addition, the soldering device may include: a magnetic induction coil stacked upward in a spiral shape; one or more magnetic cores installed to be upright at a center of the magnetic induction coil; a coil fixing body having a core insertion groove, into which each of the magnetic cores is inserted, wherein a coil insertion groove, into which the magnetic induction coil is inserted, is defined in an outer surface thereof; a body jig in which the coil fixing body is built; and a front jig and a base jig, which are installed at front and rear sides of the body jig, respectively.

In addition, a distance measuring device that passes through the body jig and the fixing body to irradiate laser toward the jig unit may be installed on the front jig and the base jig.

In addition, a magnetic core may be installed at a point of the jig unit facing the magnetic core.

### ADVANTAGEOUS EFFECTS

The induction heating soldering automation equipment configured as described above in accordance with the exemplary embodiment may locally heat the MID injection-molded product or PCB, on which the electronic components are mounted, in the non-contact manner to automatically perform the soldering of the electronic elements on the MID injection-molded product or PCB, the obtaining the plurality of soldering products having the uniform quality.

In addition, there may be the advantage in producing of the products without the thermal damage by solving the limitation of the thermal damage to the MID injection-molded product or PCB, which are impossible with the typical reflow soldering.

In addition, since there is only enough radiant heat to touch the MID injection-molded product or PCB immediately after soldering, there may be no need for cooling time to lower the temperature after the soldering.

In addition, the soldering of the MID injection-molded product made of the plastic resin having the low heat resistance may be possible to allow the wide selection of the injection-molded materials.

In addition, the induction heating device in accordance with the exemplary embodiment may have the advantage of requiring the very small device installation space and the very low electricity consumption compared to the reflow device.

### BRIEF DESCRIPTION OF THE DRAWINGS

FIG. 1 is a view illustrating an entire induction heating soldering automation equipment in accordance with an embodiment of the present invention.
FIG. 2 is a view illustrating an internal structure of an automation equipment disposed at a front side in FIG. 1.
FIG. 3 is a view illustrating an operation state of a pickup robot in the induction heating soldering automation equipment in accordance with an embodiment of the present invention.
FIG. 4 is a view illustrating an induction heating moving module in the induction heating soldering automation equipment in accordance with an embodiment of the present invention.
FIG. 5 is a view illustrating a Y-axis unit in the induction heating moving module of FIG. 4.
FIG. 6 is a flowchart illustrating an entire operation of the induction heating soldering automation equipment in accordance with an embodiment of the present invention.
FIGS. 7 and 8 are views illustrating an induction heating unit and a jig unit together in accordance with an embodiment of the present invention.
FIG. 9 is a view illustrating the jig unit in accordance with an embodiment of the present invention.
FIG. 10 is an exploded view illustrating the induction heating unit in accordance with an embodiment of the present invention.
FIG. 11 is an exploded view illustrating a magnetic induction coil and a coil fixing body of FIG. 10.
FIG. 12 is a view illustrating a magnetic core and a lower magnetic core in the induction heating unit and the jig unit in accordance with an embodiment of the present invention.
FIG. 13 is a view illustrating a fixed panel and a board (e.g., an external case of a smartphone) in the jig unit in accordance with an embodiment of the present invention.

### BEST MODE FOR CARRYING OUT THE INVENTION

Induction heating soldering automation equipment according to the present invention for achieving the above objects includes: a jig unit configured to fix a board on which an electronic element is mounted; a first conveyor configured to transfer the jig unit; an induction heating unit including a magnetic induction coil installed to be movable in X-axis, Y-axis, and Z-axis directions from an upper side of the jig unit so as to inductively heat the board mounted on the jig unit, thereby soldering the electronic element; and a controller configured to control the first conveyor and the induction

### MODE FOR CARRYING OUT THE INVENTION

Since the present invention may have diverse modified embodiments, specific embodiments are illustrated in the drawings and are described in detail. However, this does not limit the present invention within specific embodiments and it should be understood that the present invention covers all the modifications, equivalents, and replacements within the idea and technical scope of the present invention. Moreover, detailed descriptions related to well-known functions or configurations will be ruled out in order not to unnecessarily obscure subject matters of the present invention.

Hereinafter, an embodiment of induction heating soldering automation equipment in accordance with the present invention will be described in detail with reference to the attached drawings.

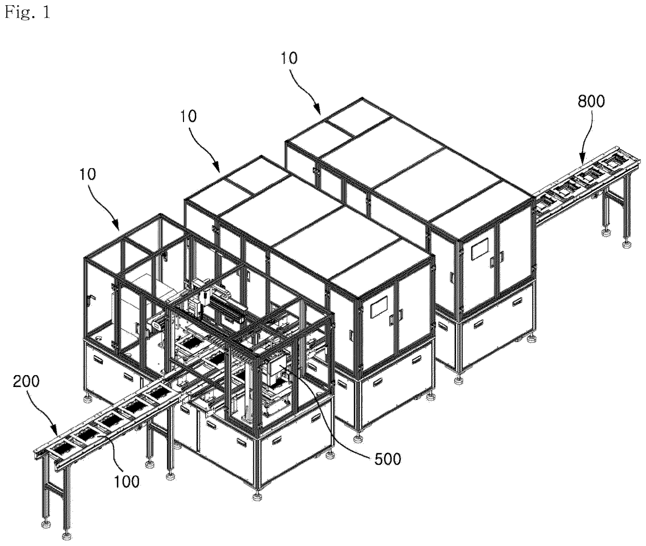

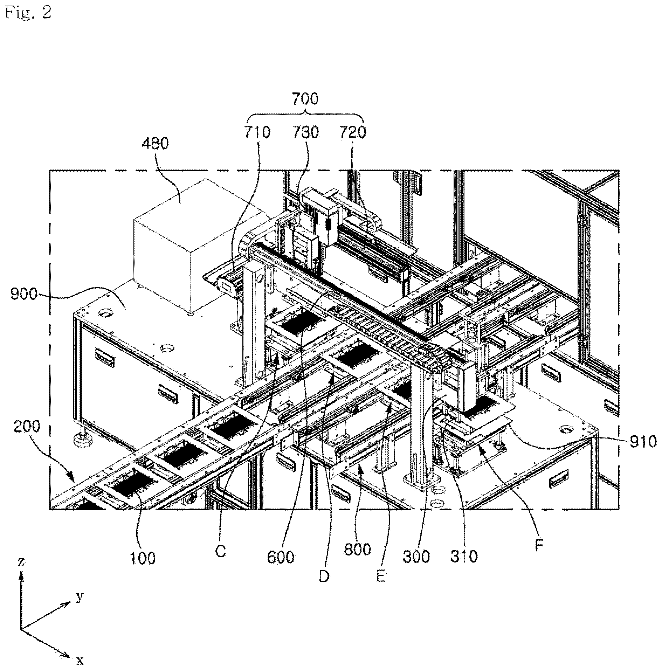

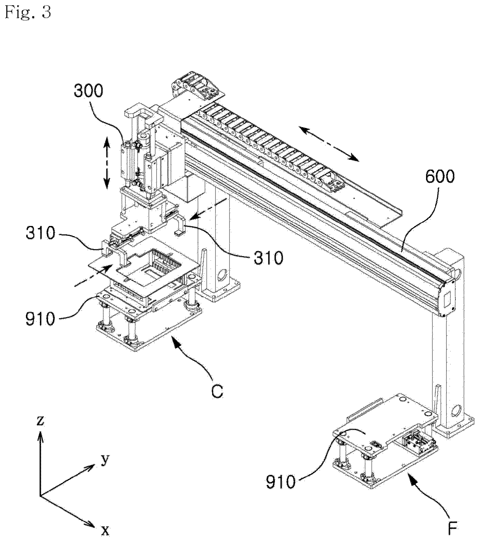

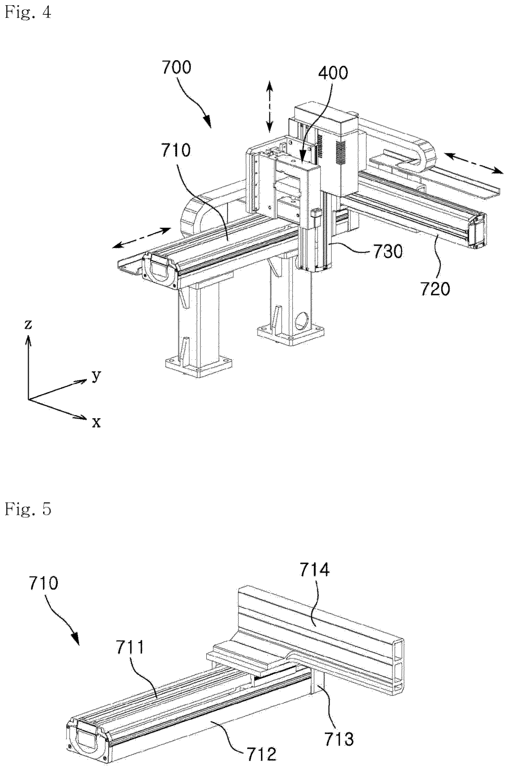

FIG. 1 is a view illustrating an entire induction heating soldering automation equipment in accordance with an embodiment of the present invention, FIG. 2 is a view illustrating an internal structure of an automation equipment disposed at a front side in FIG. 1, FIG. 3 is a view illustrating an operation state of a pickup robot in the induction heating soldering automation equipment in accordance with an embodiment of the present invention, and FIG. 4 is a view illustrating an induction heating moving module in the induction heating soldering automation equipment in accordance with an embodiment of the present invention.

The induction heating soldering automation equipment in accordance with an embodiment of the present invention may solder an electronic element on a molded interconnected device (MID) provided on an injection-molded product as well as a typical PCB or FPCB in an induction heating manner so that mold direction mount (MDM) of the electronic element is continuously and automatically performed on the injection-molded product. Here, the injection-molded product may have a curved area or a three-dimensional structure. Hereinafter, the PCB, FPCB, or MID injection-molded product on which the electronic element is mounted will be described, collectively referred to as a board A.

To describe the overall outline of the present invention in more detail, in the present invention, an induction heating unit that solders a board may automatically move in X-axis, Y-axis, and Z-axis directions to perform soldering, thereby enabling a large amount of soldering with uniform quality, and particularly, a layout such as an input and discharge of the board may be disposed in a multi-type with respect to a soldering area (soldering stage) to perform soldering for different types of lots, and a plurality of soldering devices may be continuously disposed along a transfer line to significantly improve soldering yield.

For this, as illustrated in FIGS. 1 to 4, the induction heating soldering automation equipment in accordance with an embodiment of the present invention may include a jig unit 100 configured to fix the board A on which an electronic element B is mounted, a first conveyor 200 configured to transfer the jig unit 100, a pickup robot 300 configured to hold the jig unit 100 transferred by the first conveyor 200 to move along a jig transfer rail 600 so as to pick up and transfer the jig unit 100 to a soldering area (soldering stage C), an induction heating unit 400 including a magnetic induction coil 410 configured to inductively heat the board A mounted on the jig unit 100 transferred by the pickup robot 300 so as to solder the electronic element B, and a controller 500 configured to control the first conveyor 200, the pickup robot 300, and the induction heating unit 400.

The jig unit 100 may be disposed below a soldering device to fix the board A, which is inductively heated in a non-contact manner. A detailed description of this jig unit 10 will be described later.

The first conveyor 200 may be installed to be longitudinal in a front and rear direction to transfer the jig unit 100, to which the board A, on which the electronic element B is mounted, is fixed, from a front side to a rear side.

In addition, a second conveyor 800 that transfers the jig unit 100 may be further installed next to the first conveyor 200. Thus, the board A requiring soldering of the electronic element B may be loaded into the device through the first conveyor 200, and a soldered product may be unloaded outside the device through the second conveyor 800. This will be explained in more detail later.

Referring to FIG. 3, the pickup robot 300 may move along the jig transfer rail 600 installed to be longitudinal in the X-axis direction (left and right directions) between two post structures that is upright on the base 900 of the automation equipment to transfer the jig unit 100 to the soldering stage C after holding the jig unit 100. A driver (not shown) that moves the pickup robot 300 in the X-axis direction may be installed in the jig transfer rail 600.

The pickup robot 300 may be configured to include a cylinder (not shown) having a plurality of rods and includes a pair of robot arms 310, which move to be closer or away from each other on the Y-axis to hole the jig unit 100 or release the holding of the jig unit 100, at a lower end thereof. Then, the pickup robot 300 may move the robot arm 310 in the Z-axis direction by a hydraulic or pneumatic pressure.

In more details, the pickup robot 300, which moves along the jig transfer rail 600, may be transferred by the first conveyor 200 to apply a hydraulic or pneumatic pressure to the inside of the main body of the cylinder so as to hold the jig unit 100 disposed on the jig unit 100 or a manual stage F, which waits on a standby area D, so that a rod (not shown) of a cylinder advances downward. In addition, the pair of robot arms 310 provided at a lower end of the rod may move to be close to each other on the Y-axis so that the robot arms 310 are fitted under an upper plate 150 of the jig unit 100. In this state, if the hydraulic or pneumatic pressure is again applied to the inside of the main body of the cylinder of the transfer head 300 so that the rod of the cylinder enters the inside of the main body of the cylinder, the jig unit 100 may be lifted in the Z-axis direction. Thereafter, the pickup robot 300 may be transferred to the soldering stage C along the jig transfer rail 600, and then, the jig unit 100 may descend in the Z-axis direction to place the jig unit 100 on the soldering stage C.

When the soldering of the board A seated on the jig unit 100 is completed, the pickup robot 300 may pick up the jig unit 100 and then place the jig unit 100 on an unloading area E or the manual stage F of the second conveyor 800.

The pickup robot 300 in accordance with an embodiment of the present invention may perform the loading and the unloading of the jig unit 100, which is loaded to the first conveyor 200 or the loaded to the manual stage F, to a soldering area and an unloading area while repeating this process.

Referring to FIG. 4, the induction heating unit 400 moves in the X-axis, Y-axis, and Z-axis directions by the induction heating moving module 700 to inductively heat the board A installed on the jig unit 100, thereby soldering the electronic element B on the board A. A detailed description of this induction heating unit 400 will be described later.

The induction heating moving module 700 may be a means of moving a position of the induction heating unit 400 to correspond to a shape of the board or a position of the electronic element and may move in 3 axis directions such as the X-axis, Y-axis, and Z-axis directions.

For this, the induction heating moving module 700 may be provided as a combination of three units, for example, a Y-axis unit 710 disposed horizontally in a front and rear directions of a base 900 and supported on the base 900, an X-axis unit 720 disposed horizontally in a left and right directions of the base 900 and supported on the Y-axis unit 710, and a Z-axis unit 730 disposed vertically in a vertical direction of the base 900 and supported on the X-axis unit 720.

Thus, when the Y-axis unit 710 operates, the whole of the induction heating unit 400, the Z-axis unit 730, and the X-axis unit 720 may move in the forward and backward directions (Y-axis) of the base 900, when the X -axis unit 720 operates, the induction heating unit 400 and the Z -axis unit 730 may move in the left and right directions (X-axis) of the base 900, and when the Z -axis unit 730 operates, the induction heating unit 400 may move in the vertical direction (Z-axis) of the base 900.

As illustrated in FIG. 5, each of the units 710, 720, and 730 may be constituted by a unit body 712 provided with a guide rail 711, a driver 713 coupled to one end of the unit body 712 in a longitudinal direction, for example, a servo motor, and a slider 714 moving along the guide rail 711 of the unit body 712 while being interlocked with the driver 713. Each of the units may allow the unit body thereof to be coupled to and supported on the corresponding slider and thus may move together with the corresponding slider in each direction.

For example, the unit body of the X-axis unit 720 may be coupled to the slider of the Y-axis unit 710, the unit body of the Z-axis unit 730 may be coupled to the slider of the X-axis unit 720, and the main body of the induction heating unit 400 may be coupled to the slider of the Z-axis unit 730. Here, the case of the Z-axis unit 730 may be coupled to the slider of the X-axis unit 720 by using a separate bracket as a medium.

Thus, the induction heating unit 400 may move in the X, Y, and Z directions along three-axis movement of X, Y, and Z of each unit to move to a desired point, thereby performing the soldering.

The soldering stage C, the standby area D of the jig unit 100, the unloading area E of the jig unit 100, and the manual stage F, which are described above, will be described in more detail with reference to FIGS. 2 and 3.

As illustrated in FIGS. 2 and 3, the soldering area (soldering stage C), the standby area D of the zig unit 100 (one area of the first conveyor), the unloading area E (one area of the second conveyor), and the manual areas (manual stage F) are defined sequentially inside the soldering device 10 along the X-axis direction, and the first conveyor 200 and the second conveyor 800 may be installed to be elongated along the Y-axis direction.

Here, the first conveyor 200 may be a means that loads the board A into the device in a state in which the board A is seated on the jig unit 100, and when the first conveyor 100 is stopped, the standby area D just before the board A loaded into the device is transferred to the soldering stage C may be provided.

The second conveyor 800 may be a means that unloads the soldered board A in a state in which the board A is seated on the jig unit 100, and when the second conveyor 800 is stopped, the unloading area E just before the soldered board A is unloaded to the outside of the device may be provided.

The manual stage F may provide an area on which an operator manually loads and unloads the jig unit 100 on which the board A is mounted. The manual stage F may allow more flexibility in soldering a variety of small quantities of products.

The above-described soldering stage C, the standby area D of the first conveyor 200, the unloading area E of the second conveyor 800, and the manual stage F may be disposed along the X-axis direction on the base 900. Here, the pickup robot 300 may move along the X-axis direction on each area to perform the loading and unloading of the jig unit 100 on respective areas C, D, E, and F.

Here, the soldering stage C and the manual stage F may be generated by a seating base 910 that is fixed and supported on both sides of a top surface of the base 900 installed on the bottom of the soldering device 10. The jig unit 100 may be seated on the mounting bases 910. The first and second conveyors 200 and 800 may be fixed and supported on the top surface of the base 900 through a bracket, etc., while passing through an upper portion of the base 900 between the welding and manual stages C and F.

The controller 500 may control the positions of the pickup robot 300 and the induction heating unit 400 and the traveling of the first and second conveyors 200 and 800. An input unit for inputting various data such as soldering conditions such as a shape and material of the board, a soldering position, a soldering speed, and a high frequency generation output, or soldering purposes such as emphasis on precision, emphasis on speed, and emphasis on energy saving, and an LCD touch display as a display unit for displaying the various data may be connected to the controller 500.

The soldering device 10 including the jig unit 100, the pickup robot 300, the induction heating unit 400, the controller 500, and the induction heating moving module 700 is provided in plurality (e.g., three) spaced apart from each other along the first conveyor 200. Thus, various types of soldering products may be produced simultaneously.

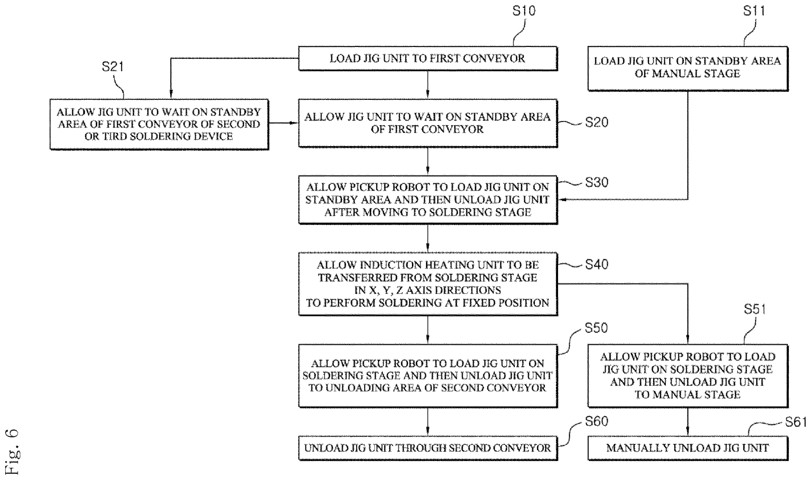

The operations of the loading and unloading of the jig unit, the soldering process, etc., by the induction heating soldering automation equipment having the above-described configuration in accordance with an embodiment of the present invention will be described with reference to FIGS. 2 and 6.

As illustrated in FIGS. 2 and 6, in the present invention, a passage through which the jig unit is loaded into the soldering device may be largely the first conveyor and the manual stage.

First, a process in which the jig unit is loaded into the first conveyor so as to be soldered and then unloaded will be described. A plurality of jig units 100 may be mounted on the first conveyor 200 at regular intervals and loaded into the soldering device 10 (operation S10). Here, the first conveyor 200 may sequentially load the jig unit 100 into the standby area D of the soldering device 10 while repeating transferring and stopping by one step (operation S20). When the jig unit 100 is disposed on the standby area D, the pickup robot 300 may move to the standby area D along the jig transfer rail 600 to pick up and place the jig unit 100 on the soldering stage C (operation S30). Thereafter, the induction heating unit 400 may receive information such as the shape of the board and the soldering position in accordance with the arrangement structure of the electronic element, which are input to the controller 500 to move in the X, Y and Z directions on the soldering stage C to the desired soldering point, thereby performing the soldering. Here, when a plurality of board A are loaded on the jig unit 100, or soldering of a plurality of electronic elements B is performed on one board A, the jig unit 100 may continuously move in the X, Y, and Z directions in accordance with control logic pre-stored in the controller 500 to perform the soldering at once on all the electronic elements B disposed on the board A provided on the jig unit 100 (operation S40). When the soldering process of all the electronic elements in the jig unit 100 is completed, the pickup robot 300 may receive a signal from the controller 500 to load the jig unit 100 on the soldering stage C and then transfer the jig unit 100 to the unloading area E of the second conveyor 800 (operation S50). The second conveyor 800 may unload the jig unit 100, on which the soldering is completed, to the outside of the device 10 (operation S60). As a result, a process of one cycle in which the jig unit is loaded into the first conveyor 200 and then unloaded after the soldering is ended.

In relation to this process, when the soldering is performed with one soldering device, the soldering may response through only one first conveyor without the second conveyor. That is to say, while the jig unit on the standby area of the first conveyor is picked up so as to perform the soldering on the soldering stage (area C), the first conveyor may continue to wait in a state in which the transfer is stopped, and then, the jig unit on which the soldering is completed may be transferred to its original standby area (area D). Here, the jig unit may move one step to continuously perform the unloading, the soldering, and the unloading. In this case, the induction heating unit 400 may directly solder the board mounted on the jig unit on the standby area (area D) of the first conveyor. That is, instead of moving the jig unit to the soldering stage (area C), the soldering may be performed by moving the induction heating unit 400 to the standby area (area D) on an inline of the first conveyor.

Next, the process in which the jig unit is loaded into the manual stage and then unloaded after the soldering will be described. The operator may place the jig unit 100 on the manual stage F. Thereafter, when the pickup robot 300 moves the jig unit 100 placed on the manual stage F to the soldering stage C, the induction heating unit 400 may perform the soldering process. This is the same process as the operations S30 and S40 described above. Here, the operator has to newly set the board information and the soldering logic of the board loaded to the manual stage through the display interlocked with the controller 500. When the soldering process of all the electronic elements in the jig unit 100 is completed in accordance with the new information of the controller 500, the pickup robot 300 may receive a signal from the controller 500 to load the jig unit 100 on the soldering stage C and then transfer the jig unit 100 again on the manual stage F (operation S51). Then, the operator may unload the jig unit disposed on the manual stage F to the outside of the device (operation S61). As a result, a process of one cycle in which the jig unit is loaded to the manual stage and then unloaded after the soldering is ended.

The soldering process using a manual stage may be used when the soldering is required for a small amount of products while soldering a large amount of products through the first conveyor. That is, when urgent soldering is required for a small amount of products, it may be possible to respond flexibly without disassembling all the jig units on the first conveyor line. As described above, the present invention may have an advantage of being able to simultaneously response to large-scale welding of small types and small-quantity welding of many types through one soldering device.

Next, the soldering process using the second or third soldering device will be described. The jig unit may be mounted on the first conveyor 200 over the second or third soldering device 10. Here, the board A may be loaded on the jig unit 100 mounted on the first conveyor 200 before the soldering. When the jig units 100 are disposed on the standby area D of the second or third soldering devices (operation S21), the operations S20 to S60 described above may be performed in the same process. When the soldering is performed using the plurality of soldering devices, it may be necessary to use the first conveyor 200 and the second conveyor 800 simultaneously. Here, the first conveyor 200 may be used as a means that loads the jig unit before the soldering into the device, and the second conveyor 800 may be used as a means that unloads the jig unit after the soldering from the device.

Hereinafter, the jig unit 100 and the induction heating unit 400, which constitute the induction heating soldering automation equipment in accordance with an embodiment of the present invention, will be described in more detail with reference to the corresponding drawings.

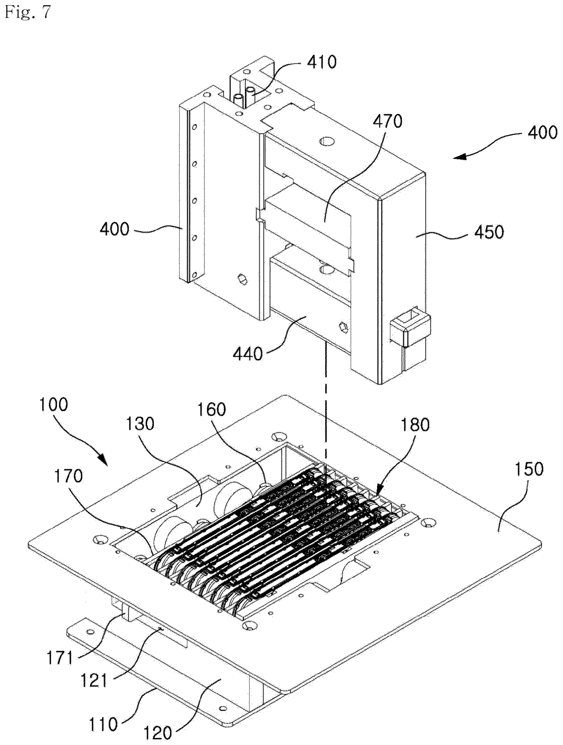

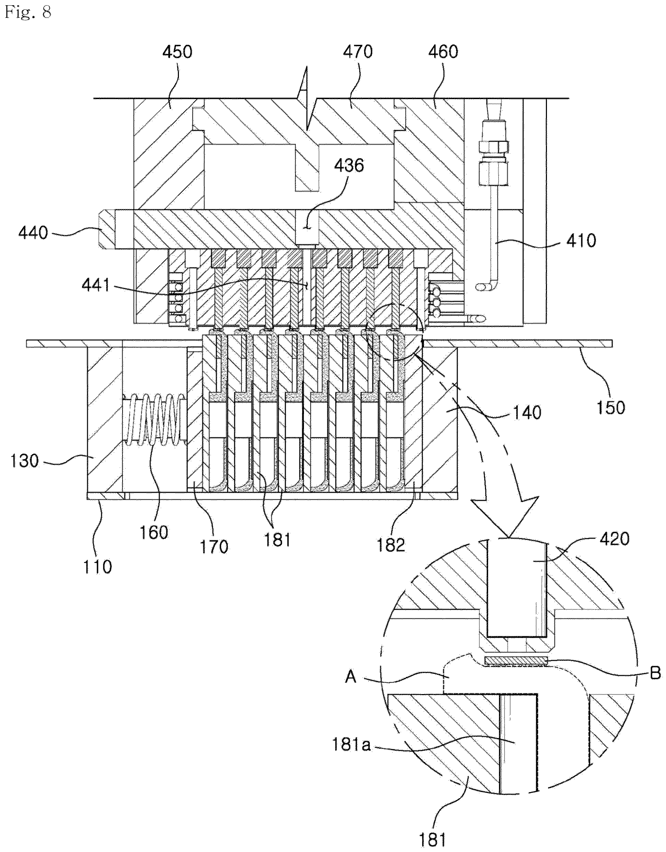

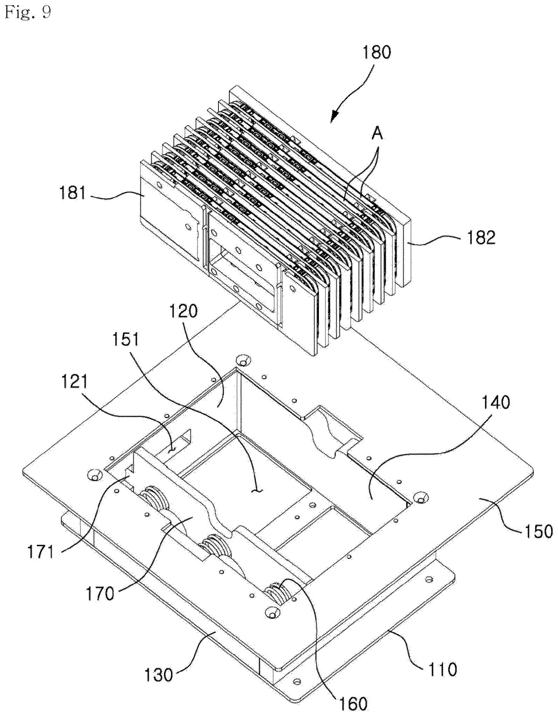

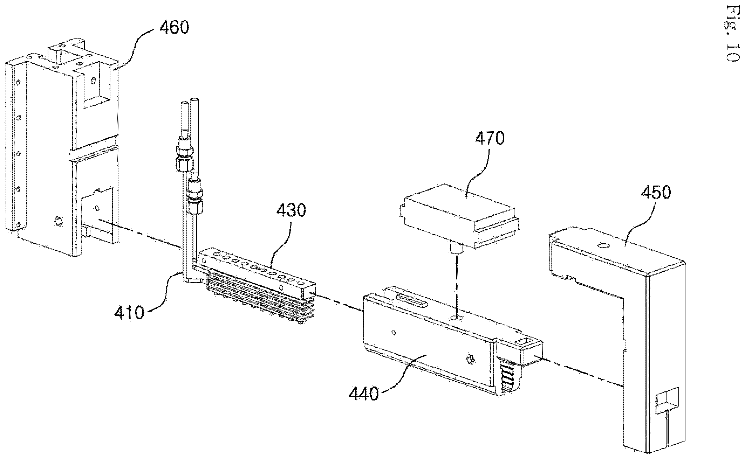

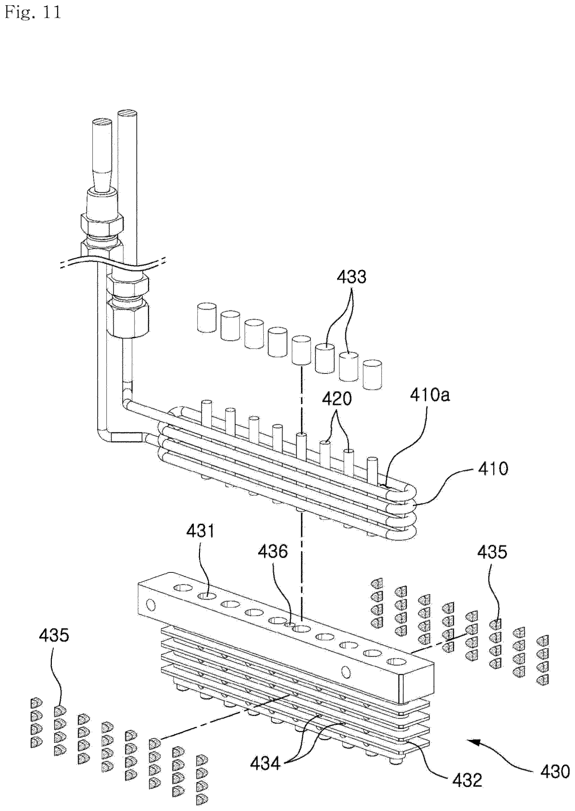

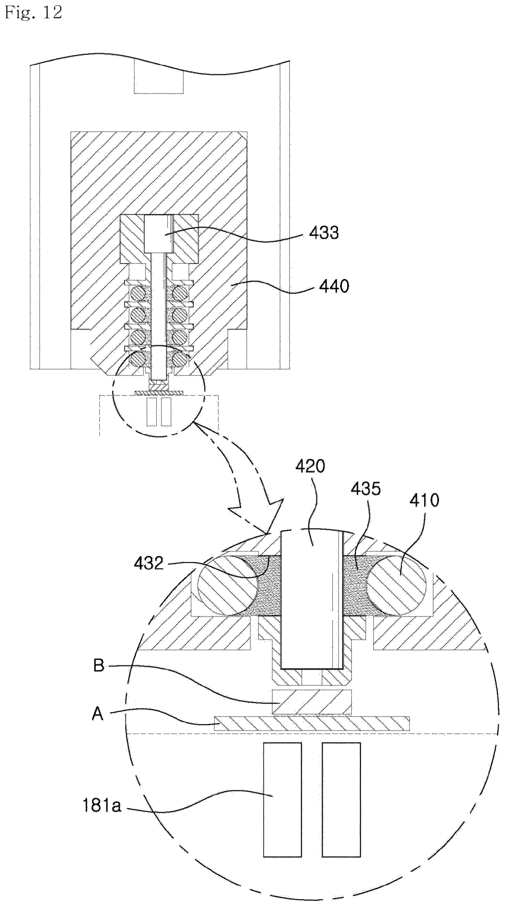

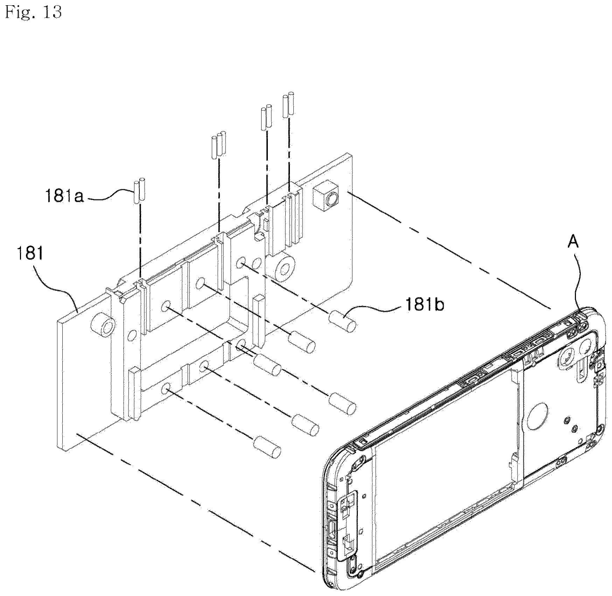

FIGS. 7 and 8 are views illustrating the induction heating unit and the jig unit together in accordance with an embodiment of the present invention, FIG. 9 is a view illustrating the jig unit in accordance with an embodiment of the present invention, FIG. 10 is an exploded view illustrating the induction heating unit in accordance with an embodiment of the present invention, FIG. 11 is an exploded view illustrating a magnetic induction coil and a coil fixing body of FIG. 10, FIG. 12 is a view illustrating a magnetic core and a lower magnetic core in the induction heating unit and the jig unit in accordance with an embodiment of the present invention, and FIG. 13 is a view illustrating a fixed panel and a board (e.g., an external case of a smartphone) in the jig unit in accordance with an embodiment of the present invention.

To describe the jig unit 100 in more detail with reference to FIGS. 7 to 9 and FIG. 13, the jig unit 100 may include a bottom plate 110, a pair of guide plates 120 installed to face each other on both ends of a top surface of the bottom plate 110, first and second support plates 130 and 140 installed to face each other on both the ends of the top surface of the bottom plate 110 on which the guide plate 120 is not installed, an upper plate 150 provided on upper ends of the pair of guide plates 120 and the first and second support plates 130 and 140, a spring 160 installed on the first support plate 130, a pressing plate 170 connected to the spring 160 to receive elastic force, and a fixing member 180 configured to fix the board A.

A guide hole 121 may be defined to be elongated in the guide plate 120.

The first support plate 130, the second support plate 140, and the pair of guide plates 120 may be respectively installed at lateral ends of edges of the bottom plate 110 to form a quadrangular shape.

An insertion hole 151 may be defined in the upper plate 150.

The spring 160 may have one end connected to the first support plate 130 and the other end connected to the pressing plate 170 to provide elastic force in a direction in which the pressing plate 170 is pushed toward the second support plate 140.

The pressing plate 170 may be provided with guide protrusions 171 at both ends thereof, and each of the guide protrusions 171 may be inserted into the guide hole 121 of the guide plate 120 to move forward and backward.

The fixing member 180 may be disposed between the second support plate 140 and the pressing plate 170 through the insertion hole 151 of the upper plate 150. The fixing member 180 may be constituted by a plurality of fixing panels 181 and a finishing panel 182 installed at one end of the fixing panel 181.

At least one magnetic core 181a may be installed on the fixing panel 181, and the plurality of fixing panels 181 may be disposed between the second support plate 140 and the pressing plate 170.

When the plurality of fixing panels 181 overlap in a horizontal direction, a gap may be defined between the fixing panels 181, and one board A may be disposed in the gap. In the plurality of fixing panels 181 described above, the first fixing panel 181 may be in contact with the pressing plate 170.

The finishing panel 182 may be installed next to the last fixed panel 181 among the plurality of fixing panels 181 that horizontally overlap each other. The board A may also be disposed between the finishing panel 182 and the fixing panel 181. In addition, the finishing panel 182 may be in contact with the second support plate 140.

A plurality of magnets 181b may be installed on the fixing panel 181 so that the adjacent fixing panels 181 are in close contact with each other by magnetic force. Alternatively, a magnet may also be installed on the finishing panel 182 to be in close contact with the adjacent fixing panel 181 by the magnetic force.

To describe the induction heating unit 100 in more detail with reference to FIGS. 7 to 8 and 10 to 12, the induction heating unit 400 may include a magnetic induction coil 410, a magnetic core 420 installed at a center of the magnetic induction coil 410, a coil fixing body 430 on which the magnetic induction coil 410 and the magnetic core 420 are installed, a body jig 440 in which the coil fixing body 430 is built, and a front jig 450 and a base jig 460, which are installed at front and rear sides of the body jig 440, respectively.

The magnetic induction coil 410 may be connected to a high-frequency power source 480 to convert electrical energy into thermal energy by electromagnetic induction and also locally heat an area requiring the soldering at a position spaced a certain distance apart to an upper side of the board A in a non-contact state to solder the electronic element B.

The magnetic induction coil 410 may be wound in a spiral shape and stacked in several layers upward. Because the magnetic induction coil is wound in the spiral shape, an internal space 410a may be defined at the center.

The magnetic core 420 may be made of a magnetic material, preferably ferrite, and be installed upright in the internal space 410a of the magnetic induction coil 410 to serve to concentrate a magnetic flux so that a heat source is concentrated to the soldering portion.

As described above, a magnetic core 181a may be also installed on the fixing panel 181 of the fixing member 180, and the magnetic core 420 installed on the magnetic induction coil 410 and the magnetic core 151a installed on the fixing panel 181 may be installed to face each other in viewpoint of concentrating the magnetic flux.

The coil fixing body 430 may be manufactured in a shape similar to a long rectangle in one direction and have at least one core insertion groove 431 into which the magnetic core 420 is inserted. In addition, a coil insertion groove 432 into which the magnetic induction coil 410 is inserted may be defined in an outer surface of the coil fixing body 430.

The core insertion groove 431 may be a hole into which the upright magnetic core 420 is inserted in the internal space 410a of the magnetic induction coil 410. A core cover 433 may be installed on an upper end of the inside of the core insertion groove 431 to prevent the magnetic core 420 from being separated to the outside.

The magnetic induction coil 410 wound in the spiral shape may be inserted into the coil insertion groove 432.

A plurality of communication holes 434 may be defined in the coil fixing body 430 to connect the magnetic core 420 to the magnetic induction coil 410.

The communication hole 434 may be defined so that the core insertion groove 431, in which the magnetic core 420 is inserted, and an outer surface of the coil fixing body 430 communicate with each other. As air flows inside the communication hole 434, the magnetic core 420 and the magnetic induction coil 410 may be cooled.

A heat dissipation sheet 435 may be installed in the communication hole 434. Thus, an inner surface of the heat dissipation sheet 435 may be in contact with an outer surface of the magnetic core 420, and an outer surface of the heat dissipation sheet 435 may be in contact with the magnetic induction coil 410 to promote the cooling of the magnetic core 420 and the magnetic induction coil 410.

The coil fixing body 430 on which the magnetic core 420 and the magnetic induction coil 410 are installed may be built in the body jig 440.

The front jig 450 and the base jig 460 may be installed on both ends of the body jig 440, respectively. When the body jig 440, the front jig 450, and the base jig 460 are connected in this manner, there is an empty space between the jigs, and a distance measuring device 470 may be installed in the empty space.

The distance measuring device 470 may be installed at each of both ends on the front jig 450 and the base jig 460 to pass through the body jig 440 and the coil fixing body 430, thereby irradiating laser toward the jig unit 100.

The distance measuring device 470 may irradiates the laser toward the jig unit 100 to measure a distance between the magnetic core 420 and the electronic element B mounted on the board A. Thus, the magnetic core 420 and the electronic element B may be disposed at optimal positions, at which uniform and high-quality soldering is obtained, by using the distance measuring device 470.

As described above, laser through-holes 436 and 441 through which the laser irradiated from the distance measuring device 470 passes may be defined to be connected to the coil fixing body 430 and the body jig 440.

The induction heating soldering device in accordance with an embodiment of the present invention may improve precision and stability by performing the soldering process for the electronic element through individual induction heating and may greatly reduce a time and power consumption required for soldering the entire board.

In addition, since the induction heating unit moves adjacent to the electronic element to solder the electronic element, a process of heating and cooling the entire board may be omitted. In relation to this process, in a typical reflow-type soldering device, a process of heating the entire board and then cooling the entire board again may be performed. Thus, since the board is heated at a low temperature to uniformly melt solder paste disposed on the entire board and prevent plating wiring and other components from being thermally damaged, there is a limit to increase in time required for the soldering, a chamber and oven for heating are required, and the entire board has to secure a space in which the entire board moves to perform each process. In addition, since a separate cooling process is required, a moving device and cooling facility may be required for the cooling process, and an additional cooling time may be required. However, the soldering automation equipment in accordance with an embodiment of the present invention may solve all of these limitations.

Although each embodiment of the present invention has been described above with reference to the drawings, It will be apparent to those skilled in the art that various modifications and variations can be made in the present invention within the scope without departing from the spirit and scope of the present invention as set forth in the following patent claims.

In an embodiment of the present invention, although an external case of a mobile phone, which is a MID product, is used as an example as a soldering object, the electronic devices in accordance with various embodiments may not be limited thereto and may be applied to all types of electronic devices that require the soldering process. For example, the electronic devices may be wearable devices such as smart watches or AR glasses, display devices, home appliances, vehicle parts, LED lamps, touch panels, antenna modules, etc.

### INDUSTRIAL APPLICABILITY

The present invention relates to induction heating soldering automation equipment and may be widely used in the electronic/electrical industries and mechanical industries, in which elements are soldered to a PCB for connection, control, and sensing between components.

## Claims

1. Induction heating soldering automation equipment comprising:
a jig unit (100) configured to fix a board (A) on which an electronic element (B) is mounted;
a first conveyor (200) configured to transfer the jig unit (100) ;
an induction heating unit (400) comprising a magnetic induction coil (410) installed to be movable in X-axis, Y-axis, and Z-axis directions from an upper side of the jig unit (100) so as to inductively heat the board (A) mounted on the jig unit (100), thereby soldering the electronic element (B); and
a controller (500) configured to control the first conveyor (200) and the induction heating unit (400).

2. The induction heating soldering automation equipment of claim 1, further comprising a pickup robot (300) configured to pick up the jig unit (100) transferred by the first conveyor (200) so as to move on a soldering stage (C).

3. The induction heating soldering automation equipment of claim 2, wherein a soldering device comprising the induction heating unit (400), the pickup robot (300), and the controller (500) is provided in plurality along the first conveyor (200).

4. The induction heating soldering automation equipment of claim 3, wherein a second conveyor (800) configured to transfer the jig unit (100) is further installed next to the first conveyor (200).

5. The induction heating soldering automation equipment of claim 4, wherein a manual stage (F) to/from which the jig unit (100) is manually loaded and unloaded is provided next to one side of the first conveyor (200).

6. The induction heating soldering automation equipment of claim 5, wherein the soldering stage (C), a standby area (D) of the first conveyor (200), an unloading area (E) of the second conveyor (800), and the manual stage (F) are disposed in a straight line along an X-axis direction, and
the pickup robot (300) performs the loading and unloading of the jig unit (100) to the respective areas (C, D, E, and F) while moving along the X-axis direction on the respective areas (C, D, E, and F) .

7. The induction heating soldering automation equipment of claim 5, wherein the induction heating moving module (700) configured to move the induction heating unit (400) in a three-axis directions such as X, Y, Z axis directions is provided as a combination of a Y-axis unit (710) supported on a base (900) of a soldering device (10), an X-axis unit (720) supported on the Y-axis unit (710), and a Z-axis unit (730) supported on the X-axis unit (720), and
each of the units (710, 720, 730) is provided with a unit body (712) provided with a guide rail (711), a driver (713) coupled to one end of the unit body (712) in a longitudinal direction, and a slider (714) moving along the guide rail (711) by driving of the driver (713).

8. The induction heating soldering automation equipment of claim 7, wherein the pickup robot (300) is provided with a pair of robot arms (310) which move along the jig transfer rail (600) in an X-axis direction and are closer or away from each other on the Y-axis to hole the jig unit (100) or release the holding of the jig unit (100), at a lower end thereof,
wherein the robot arms (310) moves in a Z-axis direction by a hydraulic or pneumatic pressure.

9. The induction heating soldering automation equipment of claim 1, wherein the board (A) comprises a PCB, an FPCB, or an MID injection-molded product.

10. The induction heating soldering automation equipment of claim 1, wherein the jig unit (10) is provided with a pressing plate (170) having one side coupled to a spring (160) and configured to press and fix a plurality of boards.

11. The induction heating soldering automation equipment of claim 1, wherein the jig unit (100) comprises:
a bottom plate (110);
a pair of guide plates (120) installed to face each other on both ends of a top surface of the bottom plate (110);
first and second support plates (130, 140) installed to face each other on both the ends of the top surface of the bottom plate (110);
an upper plate (150) provided on upper ends of the pair of guide plates (120) and the first and second support plates (130, 140) and having an insertion hole (151);
a spring (160) installed on the first support plate (130);
a pressing plate (170) configured to receive elastic force from the spring (160) and moving in a state in which a guide protrusion (171) provided at each of both ends thereof is fitted into the guide hole (121);
a fixing member (180) disposed between the second support plate (140) and the pressing plate (170) through the insertion hole (151) of the upper plate (150) and configured to fix the board (A).

12. The induction heating soldering automation equipment of claim 11, wherein the fixing member (180) comprises:
a plurality of fixing panels (181) disposed between the second support plate (140) and the pressing plate (170) to generate a gap in which the board (A) is disposed; and
a finishing panel (182) installed on an end of one side of each of the fixing panels (181) so as to be in contact with the second support plate (140).

13. The induction heating soldering automation equipment of claim 1, wherein the soldering device (400) comprises:
a magnetic induction coil (410) stacked upward in a spiral shape;
one or more magnetic cores (420) installed to be upright at a center of the magnetic induction coil (410);
a coil fixing body (430) having a core insertion groove (431), into which each of the magnetic cores (420) is inserted, wherein a coil insertion groove (432), into which the magnetic induction coil (410) is inserted, is defined in an outer surface thereof;
a body jig (440) in which the coil fixing body (430) is built; and
a front jig (450) and a base jig (460), which are installed at front and rear sides of the body jig (440), respectively.

14. The induction heating soldering automation equipment of claim 13, wherein a distance measuring device (470) that passes through the body jig (440) and the fixing body (430) to irradiate laser toward the jig unit (100) is installed on the front jig (450) and the base jig (460).

15. The induction heating soldering automation equipment of claim 13, wherein a magnetic core (181a) is installed at a point of the jig unit (100) facing the magnetic core (420).
